# EUROPÄISCHE PATENTSCHRIFT

(11) **EP 1 451 384 B1**
(45) Veröffentlichungstag und Bekanntmachung des Hinweises auf die Patenterteilung: **09.03.2005**
(21) Anmeldenummer: 02787904.8
(22) Anmeldetag: 04.12.2002
(51) Int. Cl.: C23C 14/00

(54) **BESCHICHTUNGSVERFAHREN UND BESCHICHTUNG**
COATING METHOD AND COATING
PROCEDE DE REVETEMENT, ET REVETEMENT Y RELATIF

(30) Priorität: 06.12.2001 DE 10159907
(43) Veröffentlichungstag der Anmeldung: 01.09.2004
(73) Patentinhaber: INTERPANE Entwicklungs- und Beratungsgesellschaft mbH & Co. KG, D-37697 Lauenförde (DE)
(72) Erfinder: LANDGRAF, Ralf, 94579 Zenting (DE); SCHMITT, Michael, 94227 Zwiesel (DE); MÖNNEKES, Jörg, 37671 Höxter (DE); HÄUSER, Karl, 37688 Beverungen (DE); BLESSING, Rolf, 34388 Trendelburg (DE); PAVIC, Davorin, 37073 Götttingen (DE); HERLITZE, Lothar, 37691 Derental (DE); HERWIG, Wilhelm, 37688 Beverungen (DE); BÖWER, Reimund, 37688 Beverungen (DE)
(74) Vertreter: Körfer, Thomas, Dipl.-Phys.
(86) Internationale Anmeldenummer: PCT/EP2002/013743
(87) Internationale Veröffentlichungsnummer: WO 2003/048406

(56) Entgegenhaltungen:
- EP-A- 0 736 612
- EP-A- 0 971 048
- WO-A-98/58100
- CH-A- 691 360
- DE-A- 19 753 624
- US-A- 5 439 574
- US-B1- 6 245 690

## Beschreibung

Die Erfindung betrifft ein Verfahren zur Aufbringung von einer oder mehreren Schichten auf einem Substrat in einer Vorrichtung mit PVD-Beschichtungskammer, wobei ein Feststoff wenigstens teilweise physikalisch in die Gasphase überführt und aus der Gasphase auf dem Substrat abgeschieden wird, sowie gemäß dem Verfahren hergestellte Schichten.

Im Stand der Technik (z. B. aus Kienel, Röll, "VakuumBeschichtung 2", VDI-Verlag, 1995, ISBN 3-18-401312-X, Kap. 5 Und Kap. 10) sind verschiedene Beschichtungsverfahren bekannt.

Über die sogenannten PVD-Verfahren (PVD - engl.: Physical Vapor Deposition) können Metall- oder Metalloxidschichten auf ein Substrat aufgebracht werden. Unter den PVD-Verfahren werden Vakuum-Beschichtungsverfahren zur Herstellung von dünnen Schichten auf Substraten verstanden, bei denen das Beschichtungsmaterial durch rein physikalische Methoden in die Gasphase überführt wird, um nachfolgend auf den Substraten abgeschieden zu werden.

Bei einer Ausprägung dieses Verfahrens wird das Beschichtungsmaterial im Hochvakuum bis zum Übergang in den gasförmigen Zustand erhitzt. Die Erwärmung kann über elektrische Widerstandsheizung, durch Beschuß mit hochenergetischen Elektronen oder durch Laserstrahlbeschuß erfolgen. Das verdampfte Beschichtungsmaterial wird nachfolgend auf einem Substrat abgeschieden.

Zu den PVD-Verfahren zählt auch das Sputter-Verfahren, das auch als Kathodenzerstäubung bezeichnet wird. Hierbei wird in einer Vakuumkammer bei einem konstanten Gasdruck, beispielsweise 1 Pa, durch eine Gleich- oder Hochfrequenzspannung zwischen zwei Elektroden ein Plasma gezündet. Im Plasma entstehende positive Gasionen, beispielsweise Argonionen, werden beschleunigt und treffen auf einen an der Kathode angeordneten Feststoff, der auch als Target bezeichnet wird, auf. Die von den auftreffenden Argonionen aus dem Feststoff herausgeschlagenen Atome diffundieren durch das Plasma und werden auf dem an der Anode angeordneten Substrat abgeschieden.

Nachteilig bei den bekannten Verfahren ist, daß die Beschichtungsraten regelmäßig zu niedrig sind. Insbesondere bei der Beschichtung von großflächigen Substraten wie Scheibenglas, die in großen Mengen hergestellt werden, ist es aus ökonomischen Gründen erwünscht, den Durchsatz an beschichteter Flächeneinheit Scheibenglas pro Zeiteinheit zu erhöhen.

Weiterhin wird das sogenannte CVD-Verfahren (CVD - engl.: Chemical Vapor Deposition) häufig zur Beschichtung von Substraten eingesetzt. Bei diesem Verfahren wird ein Gas, das einen Reaktanten enthält, einem Substrat in einem Reaktor zugeleitet. Der Reaktant reagiert unter Energiezufuhr an der Substratoberfläche unter Bildung eines Reaktionsproduktes. Beispielsweise können unter Verwendung des CVD-Verfahrens Metalloxid- oder Metallnitridschichten aufgebracht werden.

Aufgabe der vorliegenden Erfindung ist es somit, ein Verfahren zur Beschichtung von Substraten bereitzustellen, das eine effiziente und homogene Beschichtung von Substraten erlaubt, sowie eine entsprechende Beschichtung bereitzustellen.

Die der Erfindung zugrundeliegende Aufgabe wird durch ein Verfahren gemäß Anspruch 1 gelöst. Bevorzugte Weiterbildungen sind in den Unteransprüchen angegeben. Weiterhin wird die Aufgabe auch durch eine gemäß dem erfindungsgemäßen Verfahren hergestellte Beschichtung gemäß Anspruch 10 gelöst.

Das erfindungsgemäße Verfahren kann in einer modifizierten PVD-Beschichtungskammer durchgeführt werden. Das Substrat, beispielsweise Float-Glas, wird in der Beschichtungskammer angeordnet und ein geeigneter Unterdruck angelegt. Der Unterdruck liegt beispielsweise in einem Bereich von 0,1 bis 10 Pa, bevorzugt von 1 bis 5 Pa.

Der Feststoff (bzw. das Target) wird durch ein geeignetes Verfahren verdampft. Die Verdampfung bzw. Überführung des Feststoffs in die Gasphase kann vorzugsweise durch Erhitzen beispielsweise induktives Erhitzen, Kathodenzerstäubung, Magnetron-Sputtern, Elektronen-, Ionen- und/oder Laser-Strahlbeschuß (Laser-Ablation) und Kombinationen davon bewirkt werden.

Gemäß einer bevorzugten Ausführungsform erfolgt die Überführung des Feststoffs in die Gasphase durch Kathodenzerstäubung bzw. Sputter-Verfahren, wobei zwischen Kathode und Anode ein Plasma erzeugt wird.

Die wenigstens eine weitere Verbindung und/oder das wenigstens eine weitere Metall können über wenigstens eine Zuführung der PVD/CVD-Beschichtungskammer in gasförmiger Form zugeleitet werden. Die vorgenannten Verbindungen bzw. Metalle können aber auch in flüssiger Form, beispielsweise als Aerosol, zugeführt mittels eines Trägergases, in die Beschichtungskammer eingebracht werden. Bevorzugt erfolgt die Zuführung der vorgenannten Verbindungen bzw. Metalle in gasförmiger Form.

Die Zuführungen sind dabei entsprechend der Geometrie der Beschichtungskammer an oder in der Beschichtungskammer so angeordnet, daß die Umsetzung der wenigstens einen zugeführten Verbindung und/oder des wenigstens einen zugeführten Metalls über die gesamte Substratoberfläche gleichmäßig erfolgt. Auf diese Weise wird eine schnelle Umsetzung an der gesamten Substratoberfläche unter Ausbildung einer homogenen Beschichtung bewirkt.

Bei einer sehr bevorzugten Ausführungsform der Erfindung ist die wenigstens eine weitere Verbindung bzw. das wenigstens eine weitere Metall im Sputtergas enthalten. Als Sputtergas kann beispielsweise ein inertes Gas, beispielsweise ein Edelgas, bevorzugt Argon, verwendet werden. Die wenigstens eine weitere Verbindung und/oder das wenigstens eine weitere Metall wird bevorzugt in Gasform mit dem Sputtergas, beispielsweise in einer Mischkammer, vermengt. Das so erzeugte Gasgemisch kann dann in die PVD-Beschichtungskammer auf herkömmliche Art und Weise eingebracht werden.

Das erfindungsgemäße Verfahren stellt somit eine Kombination von PVD- und CVD-Verfahren dar.

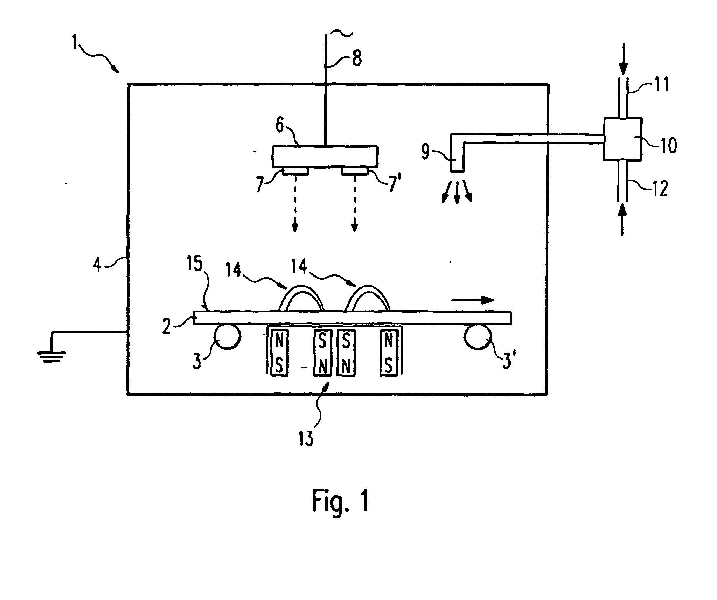

In der Fig. 1 ist beispielhaft eine Beschichtungskammer 1 für ein solches erfindungsgemäßes Verfahren dargestellt. In der Beschichtungskammer 1 wird ein Substrat 2 beschichtet, wobei dass Substrat 2 auf Rollen 3, 3' in der durch den Pfeil angegebenen Richtung transportiert wird. Die Beschichtungskammer 1 ist von einer Umwandung 4 räumlich begrenzt, die auf einem Massepotential 5 liegt.

In der Beschichtungskammer 1 ist eine Kathode 6 angeordnet, auf der im dargestellten Ausführungsbeispiel zwei Targets 7 und 7' angeordnet sind. Die Kathode 6 kann beispielsweise mit einer Wechselspannung beaufschlagt werden und ist hierzu mittels einer elektrischen Zuleitung 8 mit einem Generator verbunden. Der Materialauftrag auf der Oberfläche 15 des Substrats 2 erfolgt durch Absputtern des Beschichtungsmaterials von dem Target 7 sowie dem Target 7'. Das abgesputterte Material kondensiert dann auf der Oberfläche 15 des Substrats 2.

Um von dem Target 7 und dem Target 7' Material abzusputtern, wird in der Beschichtungskammer 1 ein Plasma gezündet. Zum Zünden des Plasmas ist in der Beschichtungskammer 1 ein Sputtergas vorhanden, welches über eine Gaszuführungsöffnung 9 in die Beschichtungskammer 1 eingebracht wird.

Über die Gaszuführungsöffnung 9 ist es außerdem möglich, zusätzlich zu dem Sputtergas eine weitere Verbindung oder ein weiteres Metall in die Beschichtungskammer 1 einzubringen, indem die weitere Verbindung oder das weitere Metall einer Mischkammer 10 zugeführt wird. An die Mischkammer 10 sind eine erste Zuführungsleitung 11 sowie eine zweite Zuführungsleitung 12 angeschlossen, über die das Sputtergas sowie die weitere Verbindung bzw. das weitere Metall der Mischkammer 10 zugeleitet werden. Das Gemisch aus dem Sputtergas und der weiteren Verbindung, die ein beschichtendes Gas ist, oder einem verdampften Metall, wird dann gemeinsam über die Gaszuführungsöffnung 9 in die Beschichtungskammer 1 eingebracht.

Um die Beschichtungsrate zu erhöhen, ist auf der von der Kathode 6 abgewandten Seite des Substrats 2 ein Magnetron 13 angeordnet. Das Magnetron 13 erzeugt ein Magnetfeld 14, welches auf der Oberseite direkt über der Oberfläche 15 des Substrats 2 wirkt. Das Magnetfeld 14 bewirkt eine Erhöhung der Plasmadichte über der Oberfläche 15 des Substrats 2. Es hat sich dabei gezeigt, dass die erhöhte Plasmadichte über dem Substrat 2 zu einer Verbesserung der Beschichtungsrate beim Auftragen einer homogenen Schicht auf der Oberfläche 15 des Substrats 2 führt.

Die weitere Verbindung, welche über die Mischkammer 10 mit dem Sputtergas vermischt wird, ist selbst bereits ein schichtbildendes Gas. An Stelle einer solchen gasförmigen weitere Verbindung kann der Mischkammer 10 auch ein Aerosol zugeführt werden, welches in der Mischkammer 10 mit dem Sputtergas vermischt wird und ebenfalls über die Gaszuführungsöffnung 9 in die Beschichtungskammer 1 eingebracht wird.

Alternativ zu der dargestellten Ausführungsform, bei dem die Vermischung der weiteren Verbindung bzw. des weiteren Metalls mit dem Sputtergas außerhalb der Beschichtungskammer 1 in der Mischkammer 10 erfolgt, kann die Vermischung auch innerhalb der Beschichtungskammer 1 durchgeführt werden. Dabei kann auf eine Mischkammer 10 auch vollständig verzichtet werden. Die einzelnen Komponenten werden dann über separate Gaszuführungsöffnungen direkt in die Beschichtungskammer 1 eingeleitet und vermischen sich dann direkt in der Beschichtungskammer 1.

Ebenfalls nur beispielhaft ist die Darstellung einer Kathode 6, auf der zwei Targets 7 und 7' als planare Targets angeordnet sind. Ebenso ist die Verwendung von Rohrkathoden der anderer Systeme zum Durchführen eines PVD-Prozesses denkbar.

Es hat sich völlig überraschend gezeigt, daß das erfindungsgemäße Verfahren das Aufbringen einer äußerst homogenen Beschichtung insbesondere auf großflächigen Substraten, wie beispielsweise Scheibenglas, in kürzerer Zeit erlaubt, verglichen mit herkömmlichen Verfahren.

Das Plasma wird bei dem erfindungsgemäßen Verfahren in der Beschichtungskammer bei konstantem Gasdruck durch eine Gleich- oder Hochfrequenzspannung zwischen Kathode und Anode gezündet. Gemäß einer bevorzugten Weiterentwicklung werden mehrere Kathoden, beispielsweise zwei Kathoden, die als Doppelkathoden ausgebildet sein können, verwendet. Der Gasdruck kann in einem Bereich von 0,1 bis 10 Pa, bevorzugt von 1 bis 5 Pa liegen. Für die Hochfrequenzspannung wird vorzugsweise eine Spannung von etwa 600V sowie eine Frequenz im Bereich von 1 bis 500 kHz.

Die plasmagestützte Beschichtung kann auch im Impulsmodus erfolgen. Beispielsweise kann bei dem erfindungsgemäßen Verfahren das Plasma wie bei dem Plasma-Impuls-PVD-Verfahren gepulst werden.

Bei dem Plasma-Impuls-PVD-Verfahren wird in der Regel bei kontinuierlichem Fluß der Beschichtungsgase die das Plasma anregende elektrische Leistung gepulst zugeführt, wobei sich bei jedem Puls eine dünne Schicht auf dem Substrat bildet.

Dadurch, daß jedem Leistungsimpuls eine Impulspause folgt, können äußerst vorteilhaft auch nicht temperaturstabile Substrate während eines Pulses mit hohen Leistungen beaufschlagt werden. Beispielsweise erlaubt das Plasma-Impuls-PVD-Verfahren, die Aufbringung von Beschichtungen auf Substrate aus Polymermaterialien, beispielsweise Polymethylmethacrylat, die temperaturempfindlich sind.

Gemäß einer bevorzugten Ausführungsform wird das Plasma in einer Doppel-Ionenquelle erzeugt.

Bei den Ionen kann es sich um Ionen des Füllgases oder auch um Ionen des Beschichtungsmaterials handeln. Der Druck kann dabei in einem Bereich von 0,1 bis 10 Pa, bevorzugt in einem Bereich von 1 bis 5 Pa, liegen. Die hochenergetischen Ionen der Doppel-Ionenquelle besitzen vorzugsweise eine Energie von etwa 100 eV bis zu einigen keV.

Gemäß einer weiteren sehr bevorzugten Ausführungsform wird das Plasma mittels eines umgekehrten Magnetrons erzeugt. Unter einem umgekehrten Magnetron wird im Sinne der Erfindung verstanden, daß ein Magnetfeld von einem Mangetron erzeugt wird, welches auf der von der zu beschichtenden Oberfläche abgewandten Seite des Substrats angeordnet wird und nicht, wie bei dem Kathodenzerstäubungsverfahren üblich, kathodenseitig hinter dem Targetmaterial. Durch ein solchermaßen hinter dem Subtrat angeordnetes Magnetron wird auch auf derjenigen Seite des Substrats ein Mangetfeld erzeugt, zu der die zu beschichtende Oberfläche orientiert ist. Damit stellt sich eine erhöhte Plasmadichte auch direkt über dem Substrat ein, die zu einer höheren Beschichtungsrate führt.

Bei diesem Verfahren ist die Beschichtung ausschließlich abhängig von der Art des Füllgases. Wird der Beschichtungskammer ein Inertgas, wie z.B. Argon, zugeführt, findet ein Plasmaätzen des Substrats statt. Erfolgt die Zuführung eines dissoziierbaren Gases oder Gas-Aerosol-Gemisches, z.B. metallorganische Verbindungen, wird eine Schicht auf dem Substrat abgeschieden. Der Druck kann dabei in einem Bereich von 0,1 bis 10 Pa, bevorzugt in einem Bereich von 1 bis 5 Pa, liegen.

Gemäß weiter eine weiter bevorzugten Ausführungsform wird das Kathodenzerstäubungsverfahren mit dem CVD-Verfahren kombiniert. Als Sputterkathode wird bevorzugt eine Kathode bzw. werden bevorzugt mehrere Kathoden, beispielsweise eine Doppelkathode oder mehrere Doppelkathoden verwendet, die eine Länge von mehreren Metern, beispielsweise von 1 bis 4m aufweisen. Die Verwendung von Sputterkathoden mit den vorgenannten Abmessungen ermöglicht die Bereitstellung eines homogenen Plasmas über die gesamte Beschichtungsbreite von insbesondere großflächigen Substraten wie z.B. Scheibenglas. In diesem homogenen Plasma erfolgt die Beschichtung der Substrate mit hoher Geschwindigkeit.

Gemäß einer bevorzugten Weiterbildung der Erfindung werden die Kathoden mit einer Wechselfrequenz beaufschlagt, beispielsweise von 1 bis 500 kHz, bevorzugt von 10 bis 100kHz, um eine Abführung von Ladungsträgern zu gewährleisten. Beispielsweise garantiert ein Mittelfrequenzverfahren im bipolaren Betrieb eine im wesentlichen beschichtungsfreie Kathode zur Abführung von Ladungsträgern und somit ein zeitlich stabiles Beschichtungsverfahren.

Unter einem Mittelfrequenzverfahren im bipolaren Betrieb ist im Sinne der Erfindung eine Doppelkathodenanordnung zu verstehen, so daß die beiden im Rezipienten befindlichen Kathoden an eine Hochfrequenzspannung gelegt werden. Die Ionen erfahren je in einer Halbwelle eine Beschleunigung zur entsprechenden Kathode an der die Zerstäubung des Targets stattfindet. Diese Methode erlaubt die Herstellung von Schichten insbesondere aus nicht leitendem Material. Für die Hochfrequenzspannung wird dabei vorzugsweise eine Spannung von etwa 600V sowie eine Frequenz im Bereich von 1 bis 500 kHz verwendet.

Gemäß einer bevorzugten Ausführungsform der Erfindung werden als Kathoden herkömmliche Doppelkathoden ohne Magnetfeld, Magnetron-Doppelkathoden, Doppel-Rohrkathoden, Doppel-Ionenquellen sowie Kombinationen davon verwendet.

Äußerst bevorzugt werden als Kathoden Doppel-Rohrkathoden verwendet, weil die Abscheidung hochisolierender Schichten durch die permanente Zuführung eines unbelegten Targetbereiches ermöglicht wird.

Mit dem erfindungsgemäßen Verfahren lassen sich äußerst vorteilhaft eine oder mehrere dünne Schicht(en) auf insbesondere großflächige Substrate aufbringen. Es hat sich gezeigt, daß die aufgebrachten Schichten sehr homogen sind.

Im Sinne der Erfindung wird unter einer homogenen Beschichtung verstanden, daß beim Beschichten großer Flächen, beispielsweise bis zu 4m Breite im kompletten Beschichtungszyklus etwa 1000m Länge, über die gesamte Breite des Substrats Schichtdickengleichmäßigkeit und damit Farbkonstanz erreicht wird. Die Schichtdickengleichmäßigkeit beträgt dabei weniger als 1%.

Die aufgebrachten dünnen Schichten können Schichten aus Metallen, Metalloxiden und/oder Metallnitriden, Halbleitern, Halbleiteroxiden und/oder Halbleiternitriden sein

Es können beispielsweise definierte Schichtaufbauten aus Siliziumoxid, Siliziumnitrid, Titanoxid, und/oder Titannitrid sowie weiterer Schichten auf ein Substrat aufgebracht werden.

Bevorzugt werden als gasförmige und/oder flüssige Verbindungen und/oder kolloidal-disperse Lösungen von Metallen und/oder Metallverbindungen folgender Haupt- und Nebengruppen des Periodensystems der Elemente verwendet: Nebengruppen IVb, insbesondere Titan, Zirkonium und Hafnium; Vb, insbesondere Vanadium, Niob und Tantal; VIb, insbesondere Chrom, Molybdän und Wolfram; VIIIb, insbesondere Eisen, Kobalt, Nickel, Palladium und Platin; Ib, insbesondere Kupfer, Silber und Gold; IIb, insbesondere Zink und Cadmium sowie die Hauptgruppen III, insbesondere Aluminium, Gallium und Indium; IV, insbesondere Kohlenstoff, Silizium, Germanium, Zinn und Blei; V, insbesondere Arsen, Antimon und Wismut, sowie VI, insbesondere Selen und Tellur.

Besonders bevorzugt sind gasförmige oder lösliche metallische und/oder metallorganische Verbindungen wie z.B. TiCl₄, GeH₄, Ti [OC₃H₇]₄ , Al [OC₂H₅]₃ , Al [OC₃H₇]₃ , Al [C₅H₇O₂]₃ , Ga [C₅H₇O₂]₃, In [C₅H₇O₂] ₃, Zn[CH₃]₂, Zn [C₃H₅O₂] ₂, Sn [CH₃]₄, Ta [OC₄H₉] ₅, Zr [OC₄H₉] ₄, Hf [OC₄H₉]₄ oder Mischungen davon.

Zur Aufbringung von Schichten aus Siliziumoxid oder Siliziumnitrid eignen sich insbesondere kolloidal-disperse Lösungen und/oder lösliche Organosilane, wie z.B. SiO₂, SiH₄, Si₂H₆, Si [OC₂H₅] ₄ (TEOS), Si [OCH₃] ₄ (TMOS), [Si (CH₃)₃]₂ (HMDS), [Si (CH₃) ₃] ₂O (HMDSO), Si [CH₃] ₄ (TMS), [SiO(CH₃)₂]₄, [SiH(CH₃)₂]₂O oder Mischungen davon.

Die vorgenannten kolloidal-dispersen Lösungen werden in für CVD-Verfahren geeigneten Lösungsmitteln wie z.B. Methanol, Ethanol, Propanol, Aceton, Ether, Amide, Ester oder Amine gelöst.

Vor Zuführung der flüssigen Verbindungen und/oder kolloidal-dispersen Lösungen der Metallverbindungen oder Metalle in die PVD/CVD-Beschichtungskammer können diese beispielsweise einer Zerstäubervorrichtung oder einem Verdampfer/Vergaser für Flüssigkeiten zugeführt werden. In dieser Vergasungsvorrichtung können verschiedene Verbindungen in bestimmten Verhältnissen unter Bereitstellung eines Trägergases miteinander gemischt werden, um anschließend die Verbindung bzw. das Verbindungsgemisch in die Gasform zu überführen. Das so hergestellte Gas kann dann der PVD/CVD-Beschichtungskammer geeignet zugeführt werden.

Mit dem erfindungsgemäßen Verfahren lassen sich auf einem Substrat eine Schicht oder mehrere übereinander angeordnete Schichten mit genau definierter Dicke, Struktur, Brechungsindex und/oder Zusammensetzung aufbringen.

Beispielsweise sind folgende definierten Schichten mittels des erfindungsgemäßen Verfahrens herstellbar (n: Brechungsindex):

| | | |
|---|---|---|
| a.) | Titanoxid / TiN | 2,1 ≤ n ≤ 2,7 |
| b.) | SiOₓ / SiₓN_{y} | 1,3 ≤ n ≤ 1, 9 |
| c.) | Zinnoxid / Zinnitrid | 1,8 ≤ n ≤ 2,1 |
| d.) | Zinkoxid /Zinknitrid | 1,8 ≤ n ≤ 2,2 |

Bei den vorstehend angegebenen beispielhaften Schichten a.) bis d.), die gemäß dem erfindungsgemäßen Verfahren herstellbar sind, können jeweils im Bereich der niedrigen Brechungsindizes hydrophobe Schichten erzeugt werden.

Die hydrophobe Oberfläche weisen ein hervorragendes Schmutzenthaftungsverhalten auf und sind folglich sehr einfach zu reinigen bzw. sind selbstreinigend.

## Patentansprüche

1. Verfahren zur Aufbringung von einer oder mehreren Schichten auf einem Substrat in einer Vorrichtung mit PVD/CVD-Beschichtungskammer, wobei ein Feststoff wenigstens teilweise physikalisch durch Kathodenzerstäubung unter Verwendung eines Sputtergases in die Gasphase überführt und aus der Gasphase auf dem Substrat abgeschieden wird, wobei der Gasphase wenigstens eine weitere Verbindung und/oder ein weiteres Metall in flüssiger oder gasförmiger Form zugeführt wird und die wenigstens eine weitere Verbindung und/oder das wenigstens eine weitere Metall wenigstens teilweise mit der Oberfläche des Substrats reagiert, wobei in der Beschichtungskammer der Feststoff an der Kathode und das Substrat an der Anode angeordnet ist und zwischen Kathode und Anode ein Plasma erzeugt wird,
**dadurch gekennzeichnet,**
**dass** das Plasma unter Verwendung eines Magnetrons erzeugt wird, das auf einer von der zu beschichtenden Oberfläche des Substrats abgewandten Seite angeordnet ist, wobei durch dieses Magnetron direkt über der zu beschichtenden Oberfläche des Substrats eine erhöhte Plasmadichte erzeugt wird.

2. Verfahren gemäß Anspruch 1,
**dadurch gekennzeichnet,**
**daß** die Überführung des Feststoffes in die Gasphase durch eine Kombination von Erhitzen, Magnetron-Sputtern, Elektronen-, Ionen- und/oder Laser-Strahlbeschuß (Laser-Ablation) mit der Kathodenzerstäubung bewirkt wird.

3. Verfahren gemäß Anspruch 1 oder 2,
**dadurch gekennzeichnet,**
**daß** in der Beschichtungskammer wenigstens zwei Kathoden angeordnet sind.

4. Verfahren gemäß einem der Ansprüche 1 bis 3,
**dadurch gekennzeichnet,**
**daß** die eine oder mehreren Kathoden mit Wechselfrequenz beaufschlagt werden.

5. Verfahren gemäß Anspruch 3 oder 4,
**dadurch gekennzeichnet,**
**daß** die wenigstens zwei Kathoden als rotierende Kathoden, Doppelkathoden ohne Magnetfeld, Magnetron-Kathoden, Magnetron-Doppelkathoden, Doppel-Rohrkathoden mit oder ohne Magnetfeld und Kombinationen davon ausgebildet sind.

6. Verfahren gemäß einem der Ansprüche 1 bis 5,
**dadurch gekennzeichnet,**
**daß** die wenigstens eine weitere Verbindung und/oder ein weiteres Metall in dem Sputtergas enthalten ist.

7. Verfahren gemäß einem der Ansprüche 1 bis 6,
**dadurch gekennzeichnet,**
**daß** die Verbindungen aus der Gruppe von Verbindungen zur Herstellung dünner Schichten aus ein- oder mehrkomponentigen Oxiden, insbesondere Siliziumoxid, Titanoxiden, Chromoxid, Aluminiumoxid, Wolframoxiden, Tantaloxiden, oder aus gemischten Metalloxid/Metallnitrid, insbesondere Siliziumoxid-Siliziumnitrid, Titanoxid-Titannitrid, aus Metallnitriden, insbesondere Siliziumnitrid, Titannitrid ausgewählt werden.

8. Verfahren gemäß einem der Ansprüche 1 bis 7,
**dadurch gekennzeichnet,**
**daß** die Verbindungen aus der Gruppe von gasförmigen oder löslichen und Metall- oder Metalloxidverbindungen ausgewählt werden.

9. Verfahren gemäß einem der Ansprüche 1 bis 6,
**dadurch gekennzeichnet,**
**daß** die Verbindungen aus der Gruppe von löslichen oder gasförmigen metallorganischen Verbindungen, bevorzugt Organosiloxanen, ausgewählt werden.

10. Beschichtung,
**dadurch gekennzeichnet,**
die Beschichtung mit einem Verfahren gemäß einem der Ansprüche 1 bis 9 hergestellt ist.

11. Beschichtung gemäß Anspruch 10,
**dadurch gekennzeichnet,**
**daß** die Beschichtung eine hydrophobe Oberfläche aufweist.

## Claims

1. Method of applying one or more layers to a substrate in a device having a PVD/CVD coating chamber, wherein a solid is at least partly converted physically to the gas phase by cathode atomization using a sputtering gas and is deposited on the substrate from the gas phase, wherein at least one further compound and/or one further metal in liquid or gaseous form is fed to the gas phase and the at least one further compound and/or the at least one further metal at least partly reacts with the surface of the substrate, wherein the solid is disposed on the cathode and the substrate on the anode in the coating chamber and a plasma is generated between cathode and anode,
**characterized**
**in that** the plasma is generated using a magnetron that is disposed on a side remote from the surface of the substrate to be coated, wherein an increased plasma density is generated by said magnetron directly above the surface of the substrate to be coated.

2. Method in accordance with Claim 1,
**characterized**
**in that** the conversion of the solid to the gas phase can be brought about by a combination of heating, cathode atomization, magnetron sputtering, electron bombardment, ion bombardment and/or laser bombardment (laser ablation).

3. Method in accordance with Claim 1 or 2,
**characterized**
**in that** at least two cathodes are disposed in the coating chamber.

4. Method in accordance with any one of Claims 1 to 3
**characterized**
**in that** the one or more cathodes are subjected to alternating frequencies.

5. Method in accordance with Claim 3 or 4,
**characterized**
**in that** the at least two cathodes are designed as rotating cathodes, double cathodes without magnetic field, magnetron cathodes, magnetron double cathodes, double tubular cathodes with or without magnetic field and combinations thereof.

6. Method in accordance with any one of Claims 1 to 5,
**characterized**
**in that** the at least one further compound and/or one further metal is contained in the sputtering gas.

7. Method in accordance with any one of Claims 1 to 6,
**characterized**
**in that** the compounds are selected from the group of compounds for producing thin layers of single- or multi-component oxides, in particular silicon oxide, titanium oxides, chromium oxide, aluminium oxide, tungsten oxides, tantalum oxides or from mixed metal oxide/metal nitride, in particular silicon oxide/silicon nitride, titanium oxide/titanium nitride, from metal nitrides, in particular silicon nitride, titanium nitride.

8. Method in accordance with any one of Claims 1 to 7,
**characterized**
**in that** the compounds are selected from the group of gaseous or soluble metal or metal-oxide compounds.

9. Method in accordance with any one of Claims 1 to 6,
**characterized**
**in that** the compounds are selected from the group of soluble or gaseous organometallic compounds, preferably organosiloxanes.

10. Coating,
**characterized**
**in that** the coating is produced by a method in accordance with any one of Claims 1 to 9.

11. Coating in accordance with Claim 10,
**characterized**
**in that** the coating has a hydrophobic surface.

## Revendications

1. Procédé de dépôt d'une ou plusieurs couches sur un substrat dans un dispositif comprenant une chambre de revêtement par dépôt PVD/CVD, dans lequel un solide est converti de manière au moins partiellement physique en phase gazeuse par pulvérisation cathodique en utilisant un gaz de pulvérisation et déposé à partir de la phase gazeuse sur le substrat, dans lequel au moins un autre composé et/ou un autre métal sous forme liquide ou gazeuse est introduit dans la phase gazeuse et ledit au moins autre composé et/ou ledit au moins un autre métal réagit au moins partiellement avec la surface du substrat et dans lequel, dans la chambre de revêtement, le solide est disposé sur la cathode et le substrat sur l'anode et un plasma est généré entre la cathode et l'anode, **caractérisé en ce que** le plasma est généré en utilisant un magnétron qui est disposé sur une face opposée à la surface à revêtir du substrat, une densité de plasma élevée étant produite par ce magnétron directement au-dessus de la surface à revêtir du substrat.

2. Procédé selon la revendication 1, **caractérisé en ce que** la conversion du solide en phase gazeuse est assurée par une combinaison de chauffage, de pulvérisation par magnétron, de bombardement d'électrons, d'ions et/ou laser (ablation par laser) avec la pulvérisation cathodique.

3. Procédé selon la revendication 1 ou 2, **caractérisé en ce que** au moins deux cathodes sont disposées dans la chambre de revêtement.

4. Procédé selon l'une des revendications 1 à 3, **caractérisé en ce qu'**une fréquence alternative est appliquée à la ou aux plusieurs cathodes.

5. Procédé selon la revendication 3 ou 4, **caractérisé en ce que** les au moins deux cathodes sont réalisées sous la forme de cathodes tournantes, de cathodes doubles sans champ magnétique, de cathodes de magnétron, de cathodes doubles de magnétron, de cathodes tubulaires doubles avec ou sans champ magnétique, ainsi que des combinaisons de celles-ci.

6. Procédé selon l'une des revendications 1 à 5, **caractérisé en ce que** ledit au moins un autre composé et/ou autre métal est contenu dans le gaz de pulvérisation.

7. Procédé selon l'une des revendications 1 à 6, **caractérisé en ce que** les composés sont choisis dans le groupe comprenant des composés servant à fabriquer des couches minces à partir d'oxydes à un ou plusieurs composants, en particulier l'oxyde de silicium, les oxydes de titane, l'oxyde de chrome, l'oxyde d'aluminium, les oxydes de tungstène, les oxydes de tantale, à partir de substances mixtes oxyde métallique/nitrure métallique, en particulier l'oxyde de silicium/nitrure de silicium, l'oxyde de titane/nitrure de titane, ou à partir de nitrures métalliques, en particulier le nitrure de silicium, le nitrure de titane.

8. Procédé selon l'une des revendications 1 à 7, **caractérisé en ce que** les composés sont choisis dans le groupe comprenant des composés de métaux ou d'oxydes métalliques gazeux ou solubles.

9. Procédé selon l'une des revendications 1 à 6, **caractérisé en ce que** les composés sont choisis dans le groupe comprenant des composés organométalliques solubles ou gazeux, de préférence des organosiloxanes.

10. Revêtement, **caractérisé en ce que** le revêtement est réalisé par un procédé selon l'une des revendications 1 à 9.

11. Revêtement selon la revendication 10, **caractérisé en ce que** le revêtement présente une surface hydrophobe.
